# DEMANDE DE BREVET EUROPEEN

(11) **EP 2 405 300 A1**
(43) Date de publication de la demande: **11.01.2012**
(21) Numéro de dépôt: 10168988.3
(22) Date de dépôt: 09.07.2010
(51) Int. Cl.: G03F 7/00, G03F 7/09, B81C 1/00

(54) **Méthode de fabrication de pièces métalliques multi niveaux par un procédé du type LIGA et pièces obtenues par la méthode**

(71) Demandeur: Mimotec S.A., 1950 Sion (CH)
(72) Inventeur: GENOLET, Grégoire, 1926 Fully (CH); GLASSEY, Marc-André, 1967 Bramois (CH)
(74) Mandataire: Leman Consulting S.A.

(57) **Abrégé**

La présente invention concerne une méthode de fabrication de micro-pièces métalliques tridimensionnelles comportant au moins deux niveaux obtenus par photolithographie et électroformage. Le second niveau de ces micro-pièces est imbriqué et solidaire au premier niveau soit par au moins un orifice traversant formé dans la première couche métallique du premier niveau, soit par enrobage de la seconde couche métallique du second niveau d'au moins une portion du contour de la première couche métallique du premier niveau. De plus, le second niveau s'étend partiellement ou entièrement sur le premier niveau et sur une zone extérieure au voisinage dudit premier niveau de sorte que le contour d'une projection orthogonale du second niveau englobe tout ou partie du contour du premier niveau. Les deux niveaux pouvant être constitués par des métaux identiques ou différents.

## Description

### Domaine de l'invention

La présente invention concerne le domaine de la fabrication de micro pièces métalliques par électroformage en particulier des pièces présentant au moins deux niveaux superposés non nécessairement inclus l'un dans l'autre ayant chacun une forme prédéfinie. Certaines pièces utilisées dans l'horlogerie comme par exemple des ancres avec dard intégré, des engrenages avec dentures décalées etc., sont également des objets de l'invention ainsi que la méthode permettant de les réaliser avantageusement.

### Arrière plan technique

Le procédé de fabrication de micro pièces ou composants par irradiation d'une couche photosensible aux rayons ultraviolets suivie d'une étape d'électroformage est connu et est décrit par exemple dans le brevet EP0851295B1.

Ce procédé est dérivé de la technique LIGA (Lithographie Galvanoformung Abformung) qui consiste à:
- déposer sur un substrat une couche de 1 à 2000 µm d'une résine photosensible (photoresist);
- effectuer à travers un masque une irradiation au moyen d'un synchrotron ou par une exposition de rayons ultraviolets;
- développer, c'est-à-dire éliminer par des moyens chimiques les portions de photoresist non polymérisées et créer de ce fait une cavité ou un moule en photoresist.
- électroformer un métal dans cette cavité afin d'obtenir une micro pièce métallique.

L'avantage de cette technique est de réaliser des pièces ou composants mécaniques d'une très grande précision en X et Y et avec une épaisseur allant jusqu'à plusieurs millimètres. Il est également possible d'appliquer ce procédé en plusieurs étapes pour obtenir un composant en plusieurs niveaux, chaque niveau étant construit sur le précédent.

Ce procédé est décrit plus avant dans la demande de brevet EP1225477A1 et détaille le processus de masquage, d'irradiation et de dissolution de la partie non irradiée. Cette technique est bien connue pour la fabrication de pièces pour l'horlogerie tels que par exemple des roues dentées, des cames, bascules ou ponts.

Plusieurs techniques de fabrication de pièces multi niveaux basées sur le procédé LIGA sont décrites dans des documents de l'art antérieur à savoir :
W02007/104171A2 qui décrit une méthode de fabrication d'une pièce à deux niveaux comprenant une étape de dépôt d'une couche d'or d'accrochage sur le premier niveau de la pièce précédant le dépôt du second niveau sur le premier. Il n'y a donc pas d'assemblage entre les niveaux, les couches adhèrent de façon planaire l'une par rapport à l'autre par le biais d'une couche d'accrochage.
WO2009/083488A1 qui décrit une technique de fabrication par le procédé LIGA d'une pièce en formant un moule de photoresist sur un substrat dans lequel est déposée galvaniquement une première couche uniforme d'un premier métal et ensuite une seconde couche d'un second métal enrobant la première couche. Il s'agit ici d'enrober une pièce à 1 niveau par un métal pour former une coque.
WO2010/020515A1 qui décrit la fabrication d'une pièce à plusieurs niveaux en réalisant un moule de photoresist complet correspondant à la pièce finale à obtenir avant l'étape de dépôt galvanique du métal de la pièce dans le moule. Seules des pièces multi-niveaux dont les niveaux sont inclus l'un dans l'autre sont réalisables par cette méthode.
EP1462859A2 qui décrit un procédé multi niveaux de réalisation de pièces complexes dont les niveaux supérieurs sont un sous-ensemble des niveaux précédents. Deux niveaux différents sont formés en deux dépôts de photoresist pour former un moule. Avant la phase d'électroformage de la pièce, une couche conductrice est déposée sur les parois du moule pour que le dépôt des particules métalliques soit effectué de manière homogène. Comme dans le cas de la méthode décrite par le document précédent, seules des pièces multi-niveaux dont les niveaux sont inclus l'un dans l'autre sont réalisables selon ce procédé.

### Description sommaire de l'invention

Le but de la présente invention est de fabriquer des micro-pièces métalliques tridimensionnelles à plusieurs niveaux auto-assemblées par imbrication réalisées en plusieurs phases d'électroformage. Les différents niveaux de ces micro-pièces peuvent être composés de matériaux différents.

Ce but est atteint par une méthode de fabrication de pièces métalliques comportant au moins deux niveaux obtenus par photolithographie et électroformage, cette méthode comprend des étapes définies selon la revendication 1.

La pièce réalisée par la méthode comporte deux niveaux imbriqués l'un dans l'autre grâce à la croissance du deuxième niveau dans l'espace formé dans la première couche métallique adjacent à un flanc de celle-ci. Il s'agit d'un auto-assemblage.

Le moule du premier niveau pouvant comporter un ou plusieurs étages peut être obtenu soit par le procédé LIGA, soit par une combinaison de gravure profonde du substrat et du procédé LIGA.

Dans le cas d'un premier moule à deux étages ou plus, le contour de la cavité du moule formée par un étage supérieur s'étend soit entièrement au-delà du contour de la cavité d'un étage inférieur, soit en partie avec des portions de contour de l'étage supérieur coïncidant avec le contour de l'étage inférieur.

Selon une première variante, le flanc et l'espace adjacent forment un orifice traversant, de forme quelconque, dans la première couche métallique dont le fond est constitué par le substrat. Le pourtour de l'orifice est ainsi entièrement formé par le métal de la première couche. Le métal de la seconde couche du second niveau remplit l'orifice à partir du substrat en se liant avec le métal des flancs de l'orifice pour s'étaler sur la base du second moule en atteignant une épaisseur prédéfinie.

Selon une seconde variante, le pourtour de cet espace est formé par une portion du flanc de la première couche métallique et une portion du flanc de la seconde couche de photoresist. La forme de l'espace est ainsi définie par celle des portions de flanc de la couche métallique et de flanc de la couche de photoresist. Le métal de la seconde couche remplit l'espace en enrobant la portion de flanc de la première couche métallique. Cette portion de flanc comporte de préférence des creux et/ou des protubérances assurant un enrobage solide excluant une séparation ultérieure des niveaux par des forces de cisaillement.

Il est à noter que le nombre d'orifices et d'espaces adjacent à des portions de flancs de couche métallique n'est pas limité à un seul pour une même pièce. La première couche métallique peut en effet comporter plusieurs orifices et/ou plusieurs espaces entre le flanc de la couche et les parois de la cavité du moule.

Il est également à noter que la pièce ainsi obtenue peut être formée de différents matériaux tels que du NiP (nickel-phosphore) pour des parties devant être amagnétiques et/ou glissantes et du Ni (nickel) pour des parties nécessitant de bonnes propriétés mécaniques ressort. La pièce peut également être composée d'or et de nickel si des différences de densité sont nécessaires dans un même composant.

Selon une troisième variante, deux niveaux de résine peuvent former la cavité du moule pour le deuxième électroformage. Dans ce cas particulier, on peut ainsi définir un espacement entre le sommet du premier niveau et la base du deuxième niveau. Cet espacement étant défini par de la résine polymérisée sur le sommet du premier niveau.

Selon une quatrième variante, le moule du premier niveau peut être obtenu par une combinaison de gravure profonde du substrat et du procédé LIGA. Le contour du moule est défini par usinage du substrat selon des procédés de micro-fabrication classiques (photolithographie suivi d'une gravure profonde) et la cavité dans laquelle l'assemblage entre les niveaux va se faire est défini par un motif en photoresist.

Le photoresist permet de masquer la cavité qui va servir à la liaison entre les niveaux durant l'électroformage du premier niveau. Il sera éliminé avant la structuration du moule en photoresist du deuxième niveau de métal.

La présente invention concerne également une pièce composée d'au moins deux niveaux constitués chacun par une couche métallique obtenue par photolithographie, grâce à un moule de photoresist ou gravé dans le substrat, et par électroformage, caractérisée en ce que la couche métallique du second niveau est imbriquée et intimement liée à la couche métallique du premier niveau par au moins une portion de surface et de flanc de la couche métallique dudit premier niveau et en ce que le second niveau s'étend partiellement ou entièrement sur le premier niveau et sur une zone extérieure au voisinage dudit premier niveau de sorte que le contour d'une projection orthogonale du second niveau englobe tout ou partie du contour du premier niveau.

Les niveaux de la pièce sont intimement liés entre eux grâce à la croissance de la seconde couche métallique dans la première. Cette croissance a lieu sur tout ou partie de la surface de la première couche métallique, dans un orifice et/ou sur une portion du contour cette couche métallique. Une séparation des niveaux n'est ainsi pas possible sans détruire la pièce. Les niveaux sont ainsi auto-assemblés lors de l'électroformage du niveau supérieur et positionnés l'un par rapport à l'autre par procédé photolithographique.

### Brève description des figures

L'invention sera mieux comprise grâce à la description détaillée qui va suivre en se référant aux dessins annexés dans lesquels :
La figure 1 illustre les différentes étapes de la méthode selon l'invention pour obtenir une pièce à deux niveaux imbriqués l'un dans l'autre dont le premier niveau est défini par le procédé LIGA dans une cavité en photoresist.
la figure 2 illustre une variante de la méthode dans laquelle le moule de la partie supérieure de la pièce est défini par deux couches de photoresist. La pièce obtenue comporte un espacement entre les deux niveaux et définit ainsi une pièce à trois niveaux.
La figure 3 illustre une variante de la méthode dans laquelle la première couche métallique comporte un trou traversant qui sera rempli par le métal de la seconde couche formant le second niveau.
La figure 4 illustre une variante de la méthode dans laquelle la première couche métallique comporte un espace dont le pourtour est formé par une portion de flanc de la première couche métallique et une portion de paroi du moule de photoresist. Le métal de la seconde couche enrobe la portion du flanc de la première couche.
La figure 5 illustre les différentes étapes de la méthode selon l'invention pour obtenir une pièce à deux niveaux imbriqués l'un dans l'autre dont le premier niveau est défini par électroformage dans une cavité obtenue par une combinaison de gravure profonde du substrat et du procédé LIGA.
La figure 6 montre un exemple de pièce d'horlogerie réalisé par la méthode de l'invention en utilisant un premier moule gravé dans le substrat pour le premier niveau et deux moules de photoresist pour les deux niveaux supérieurs.
La figure 7 montre une variante dans laquelle le premier moule comporte deux étages réalisés par deux couches de photoresist, ce moule définissant le premier niveau de la pièce.
La figure 8 montre une variante dans laquelle le premier moule comporte deux étages réalisés par gravure profonde du substrat, ce moule définissant le premier niveau de la pièce.
La figure 9 montre une variante mixte dans laquelle le premier moule comporte quatre étages dont deux réalisés par gravure profonde du substrat et deux réalisés par deux couches de photoresist, ce moule définissant le premier niveau de la pièce.

### Description détaillée de l'invention

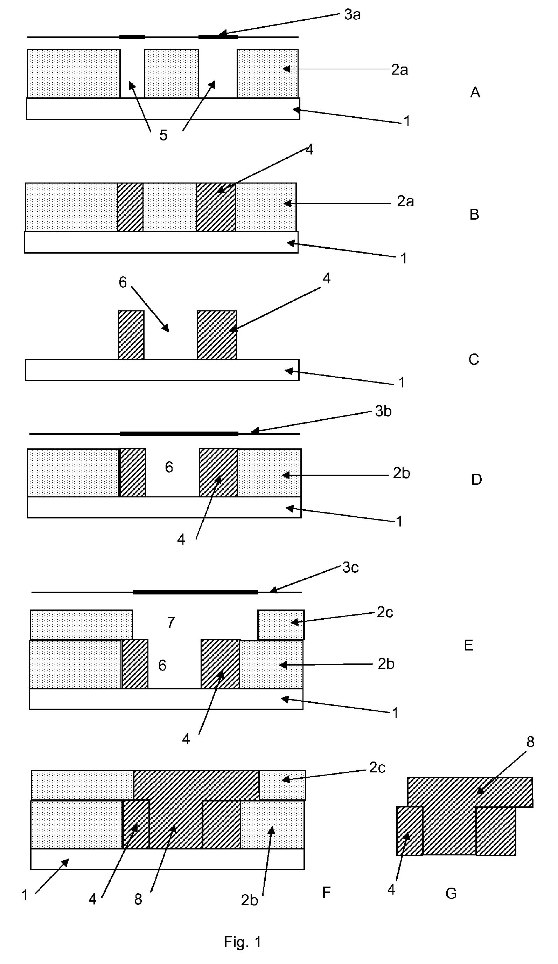

Selon les figures 1 à 4, le substrat 1 est généralement une plaque de verre, de silicium ou de métal sur laquelle est déposée une couche conductrice réalisée par exemple par une évaporation de chrome et d'or. Sur cette couche conductrice est déposée puis séchée une couche photorésist sensible aux rayons ultraviolets (ou aux rayons X selon la technologie choisie).

Cette couche de photoresist est ensuite irradiée par une source à ultraviolets à travers une plaque en verre sur laquelle a été structuré un motif en chrome. Cette plaque avec sa découpe de chrome est appelée un photomasque utilisé dans les étapes A, D et E de la méthode.

La lumière arrivant parfaitement perpendiculairement sur le photomasque, seules les portions de photorésist non protégées par le motif en chrome seront irradiées. Les flancs des portions de photoresist sont ainsi perpendiculaires au substrat.

Dans le cas particulier d'une résine négative comme par exemple le SU8, un recuit de la couche de photorésist provoque la polymérisation dans les zones ayant reçu le rayonnement UV. Cette partie polymérisée devient insensible à la plupart des solvants par opposition aux zones non irradiées qui sont dissoutes par un solvant.

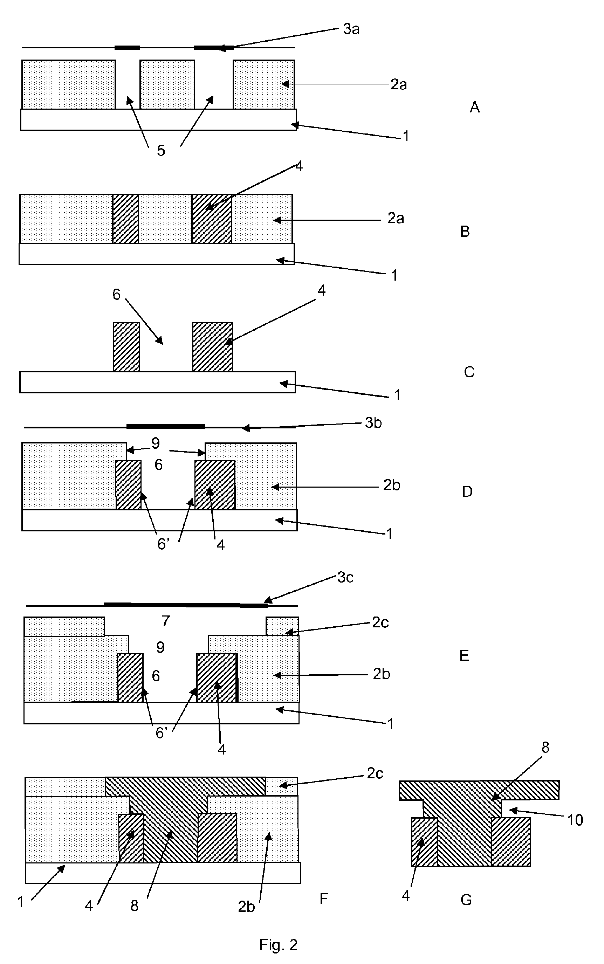

Les étapes A, B et C illustrées par les figures 1 et 2 sont des étapes de préliminaires de préparation d'une première couche métallique qui constituera le premier niveau de la pièce finale.

L'étape A consiste à déposer et irradier au travers d'un premier photomasque 3a, une première couche de photorésist 2a préalablement appliquée sur le substrat 1. Cette première couche 2a de photorésist est polymérisée selon le motif du photomasque 3a et les parties de la couche non polymérisée sont éliminées par voie chimique. La partie de photoresist restante forme un moule comportant une ou plusieurs cavités 5 dans lesquelles une première couche métallique 4 est déposée par électroformage, étape B.

La couche métallique 4 est ensuite usinée à une épaisseur prédéfinie et uniforme sur toute la surface de la couche. En effet, la surface brute d'une couche métallique électroformée est en général irrégulière et bombée par effet de champignonnage et de croissance inhomogène en épaisseur dû à la croissance du métal entre le substrat 1 et l'électrode ou les électrodes de l'outil de métallisation.

Le photoresist du moule est enlevé complètement pour ne laisser sur le substrat 1 que la première couche métallique 4 dont la forme et la structure est définie par le photomasque 3a qui a servi à la réalisation du moule, étape C. Les flancs du pourtour de la couche métallique sont perpendiculaires au substrat comme ceux du pourtour de la couche de photoresist. L'exemple de la figure 1 montre une coupe d'une couche métallique 4 en deux parties séparées par une espace 6 délimité par les flancs 6' de la couche métallique 4 et la couche métallique (non représentée) du substrat 1.

Une seconde couche de photoresist 2b est déposée sur le substrat et irradiée en utilisant un second photomasque 3b qui masque tout ou partie de la couche métallique au moins zone adjacente à une portion de flanc 6' de la couche métallique 4 formant l'espace 6. L'épaisseur de cette seconde couche de photoresist 2b est soit égale à celle de la première couche métallique 4 comme illustré par la figure 1, soit supérieure à la première couche métallique 4 comme illustré par la figure 2.

Cette seconde couche de photoresist 2b constituant la base du second niveau est polymérisée dans des zone définies par le photo masque 3b. Les autres zones non polymérisées sont éliminées de manière à laisser une partie de la couche servant à former la base ou le fond d'un moule destiné à créer le second niveau et au moins l'espace 6 traversant la première couche métallique 4 jusqu'au substrat 1. Cet espace 6 est défini par un pourtour constitué soit entièrement par le métal de la première couche métallique 4, soit par une portion du flanc 6' de ladite première couche métallique 4 et une portion de flanc 6" de la seconde couche de photorésist 2b, étape D.

A l'étape E, une troisième couche de photoresist 2c est déposée et irradiée à travers un troisième photomasque 3c dont le motif est configuré de manière à masquer une zone s'étendant partiellement ou entièrement sur la première couche métallique, une zone extérieure au voisinage de ladite couche métallique et l'espace 6 de la première couche métallique. Cette troisième couche de photoresist 2c est polymérisée et les parties non polymérisée de la couche sont éliminées. La partie polymérisée restante forme un espace 7 ou la cavité du moule du second niveau comprenant également l'espace 6 de la première couche métallique 4, cet espace 6 étant libre de photoresist.

A l'étape F une seconde couche métallique 8 et déposée par électroformage dans la cavité 7 du moule et dans l'espace 6. Le métal croît depuis le substrat 1 au fond de l'espace 6, sur les portions métalliques du pourtour de l'espace 6 et de la surface de la première couche métallique 4 à la base du second niveau de manière à occuper entièrement le moule.

Cette seconde couche métallique 8 est usinée par un procédé mécanique d'une façon similaire à la première couche métallique 4 jusqu'à une épaisseur prédéterminée.

L'étape G consiste à enlever par des moyens chimiques les couches de photoresist 2b et 2c polymérisé du moule et le substrat afin de libérer une pièce métallique constituée de deux niveaux.

Chaque niveau de cette pièce est défini par la première et la seconde couche métallique (4, 8) dont les contours sont définis par photolithographie, grâce à un moule de photoresist, et par électroformage. Le second niveau est imbriqué et intimement lié au premier niveau par une portion de flanc 6' et une portion de la surface du premier niveau. Selon la configuration du moule de photoresist lors de la réalisation du premier niveau, l'espace 6 est soit entièrement, soit partiellement entouré de métal. De plus, le second niveau s'étend à la fois partiellement ou entièrement sur le premier niveau et sur une zone extérieure au voisinage du premier niveau de sorte que le contour d'une projection orthogonale du second niveau par exemple englobe tout ou partie du contour du premier niveau ou vice versa.

La figure 2 illustre une variante de la méthode dans laquelle, à l'étape D la seconde couche de photoresist (2b) est plus épaisse que la première couche métallique 4 et couvre partiellement celle-ci. Un espace supplémentaire 9 délimité par les flanc de la couche de photoresist en surépaisseur est ainsi formé au-dessus de l'espace 6 de la première couche métallique 4 par le motif du second photomasque 3b.

Le motif du troisième photomasque 3c de l'étape E est configuré de manière à former le second moule de photoresist de sorte que le second niveau s'étende au-delà du premier niveau. La cavité du moule final de photoresist comporte ainsi trois niveaux constitués par la superposition de l'espace 6 de la première couche métallique 4, de l'espace 9 constitué par la surépaisseur de la seconde couche de photoresist 2b et de l'espace 7 délimité par les flancs de la troisième couche de photoresist 2c.

La pièce métallique obtenue à l'étape G comporte ainsi un niveau intermédiaire 10 entre le premier et le second niveau. Ces derniers étant imbriqués l'un dans l'autre par l'espace 6, le second niveau étant configuré de manière similaire à la variante précédente.

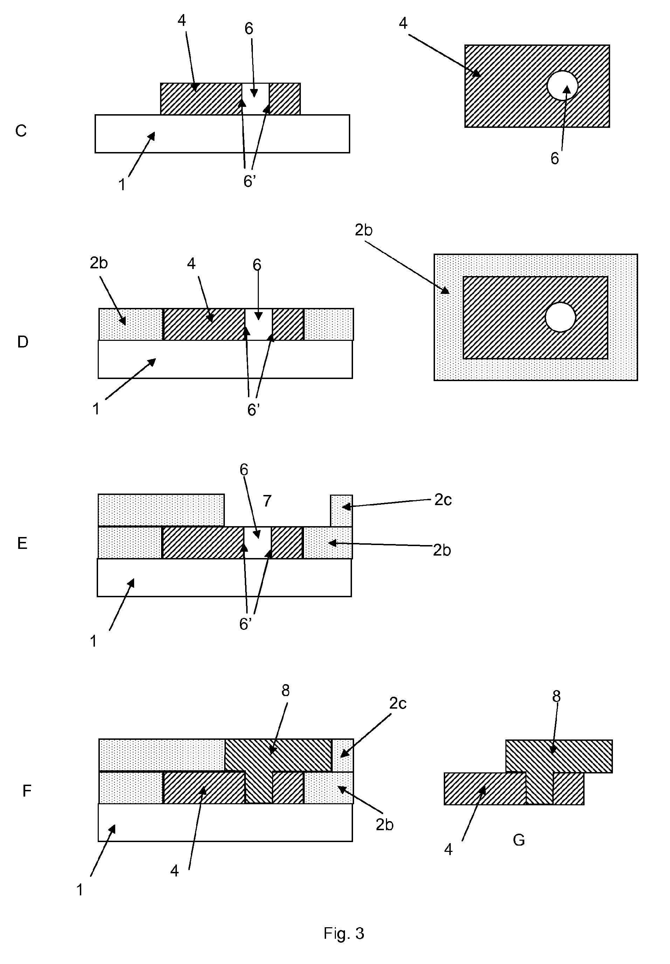

La figure 3 illustre une variante dans laquelle, l'espace 6 dans la première couche métallique 4 est entièrement entouré par le métal de cette couche en formant un orifice dont la forme est définie par le premier photomasque 3a à l'étape A. L'orifice 6 traverse entièrement la première couche métallique jusqu'au substrat 1.

Les étapes A et B ne sont pas représentée dans la figure 3 car elle sont similaires à celles des variantes des figures 1 et 2.

Dans cet exemple, la seconde couche de photoresist 2b entoure complètement la première couche métallique 4 sans laisser d'espace entre cette dernière et les flancs de la couche de photoresist 2b. Le second niveau est construit au-dessus du premier niveau au moyen du second moule dont le fond de la cavité est constitué par au moins une partie de la première couche métallique et une partie de la seconde couche de photoresist 2b polymérisée. L'orifice 6, dégagé de photoresist, est entièrement inclus à la cavité du moule servant à réaliser le second niveau.

La pièce obtenue à l'étape G après enlèvement du moule et du substrat comporte deux niveaux imbriqués avec le métal du second niveau pénétrant à travers l'orifice du premier niveau.

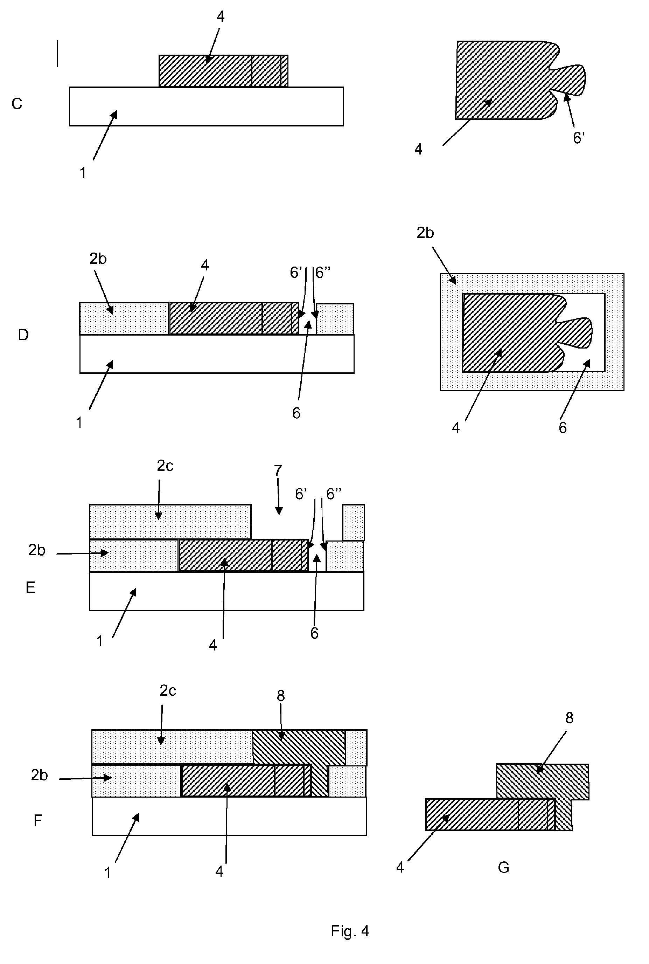

La variante de la figure 4 diffère de la variante de la figure 3 en ce que l'espace 6 n'est pas entièrement entouré du métal de la première couche métallique 4 mais également par une portion de flanc 6" de la seconde couche de photoresist 2b. Le contour de l'espace 6 est défini par le motif du second photomasque 3b configuré de manière à recouvrir une zone plus étendue que la zone occupée par la première couche métallique. Le troisième photomasque 3c utilisé pour former le moule du second niveau comporte un motif configuré de manière à laisser l'espace 6 libre de photoresist lors du dépôt la troisième couche 2c. La cavité du second moule est ainsi formée par la superposition des espaces 6 et 7 qui seront remplis par le métal du second niveau. Ce métal croît à la fois sur le substrat 1 au fond de l'espace 6 et sur la portion du flanc 6' de la première couche métallique 4 de l'espace 6 de manière à enrober la cette portion de flanc. La forme de cette portion de flanc 6' comporte de préférence une suite de parties concaves et convexes de manière à assurer un effet d'imbrication du métal du second niveau dans celui du premier niveau, et vice versa, plus accentué et sur une plus grande longueur que dans le cas d'une portion de flanc rectiligne.

De manière plus générale, le flanc de la première couche métallique le long duquel la liaison entre les niveaux est effectuée est optimisé de manière à maximiser la surface de contact. En effet pour augmenter l'effet d'imbrication et de liaison intime entre les deux couches métalliques, le contour du flanc ou des portions flancs de la première couche métallique forme de préférence une ou plusieurs lignes brisées en segments de droites et/ou de courbes.

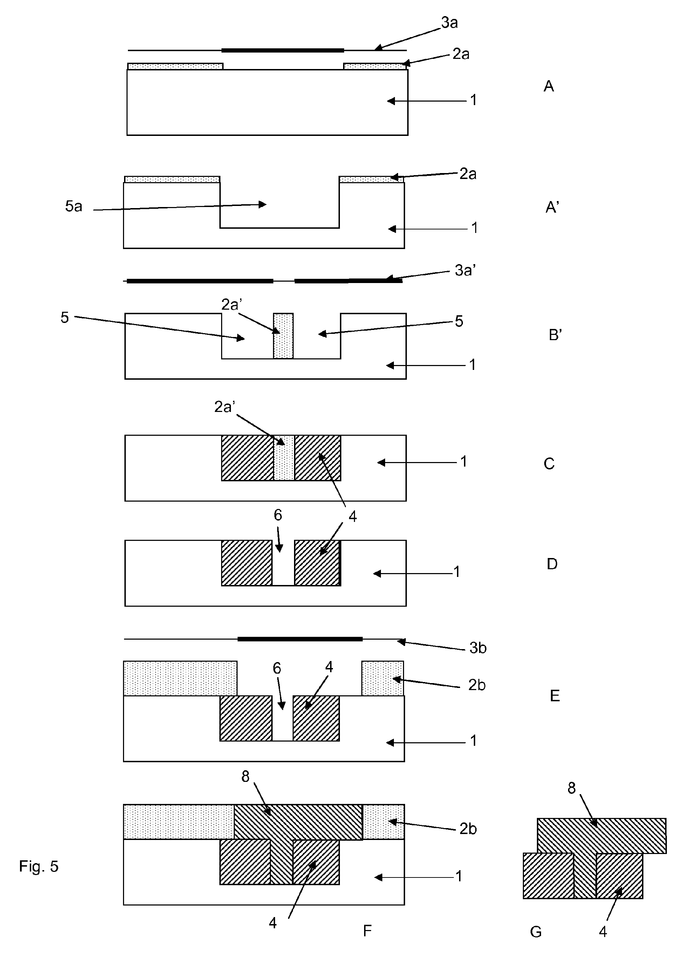

La figure 5 illustre un exemple d'une variante de la méthode dans lequel le premier moule est obtenu par une combinaison de gravure profonde du substrat et de procédé LIGA et le second moule est obtenu par le procédé LIGA uniquement.

A l'étape A, une couche de photoresist 2a est appliquée sur un substrat 1 et un premier photomasque 3a est utilisé pour définir la forme du contour du premier moule. L'opération de gravure profonde A' du substrat est effectuée en général par gravure sèche (gravure plasma, par exemple DRIE, Deep Reactive Ion Etching) ou humide (par exemple gravure KOH, hydroxyde de potassium) impliquant une attaque chimique sélective des parties du substrat non protégées par la résine structurée par illumination à travers le photomasque 3a. De cette gravure profonde résulte une cavité 5a constituant une première partie du moule 5 du premier niveau.

A l'étape B, une couche de photoresist supplémentaire 2a' est déposée et irradiée au travers d'un photomasque supplémentaire 3a' de manière à créer une couche s'étendant partiellement sur le substrat au fond de la cavité 5a. L'épaisseur de cette couche peut être supérieure, inférieure ou égale à la profondeur de la cavité 5a et son contour est défini par le photomasque 3a'. Les contours de la cavité 5a et de la couche de photoresist 2a' et les parties de la cavité non occupées par le photoresist définissent le premier moule servant à former le premier niveau de la pièce finale. Une fois polymérisée, la couche de photoresist dans la cavité empêche, lors de l'étape C, l'électroformage de la première couche métallique (4) en permettant la croissance de la couche métallique seulement dans les parties du moule libres de photoresist.

A l'étape D, la couche supplémentaire de photoresist 2a' est enlevée pour laisser un espace 6 délimité par au moins un flanc de la couche métallique 4, le substrat 1 et le fond de la cavité du premier moule 5. La surface de la première couche métallique 4 est ensuite usinée mécaniquement à une épaisseur prédéfinie.

A l'étape E, une seconde couche de photoresist 2b est appliquée sur le substrat 1 avec un second photomasque 3b de manière à s'étendre à la fois sur le substrat 1 et/ou sur au moins une partie de la première couche métallique 4, l'espace 6 étant protégé par le photomasque 3b. Cette seconde couche de photoresist 2b constitue le moule du second niveau.

Après polymérisation et élimination du photoresist non polymérisé, une seconde couche métallique 8 est déposée par électroformage dans le moule à l'étape F. Cette seconde couche métallique 8 croît depuis le substrat 1 au fond de la cavité, dans l'espace 6 le long des flancs de la première couche métallique 4, sur la première couche métallique 4 et sur la surface du substrat 1 dans le voisinage de la première couche métallique 4 afin d'occuper entièrement le moule du second niveau.

La surface de cette seconde couche métallique 8 est également usinée à une épaisseur prédéfinie avant l'enlèvement du substrat 1 et du photoresist polymérisé 2b du moule. La pièce métallique obtenue comporte ainsi deux niveaux auto assemblés non nécessairement inclus l'un dans l'autre similaire à une pièce obtenue par les variantes de la méthode illustrées par les figures 1, 3, et 4.

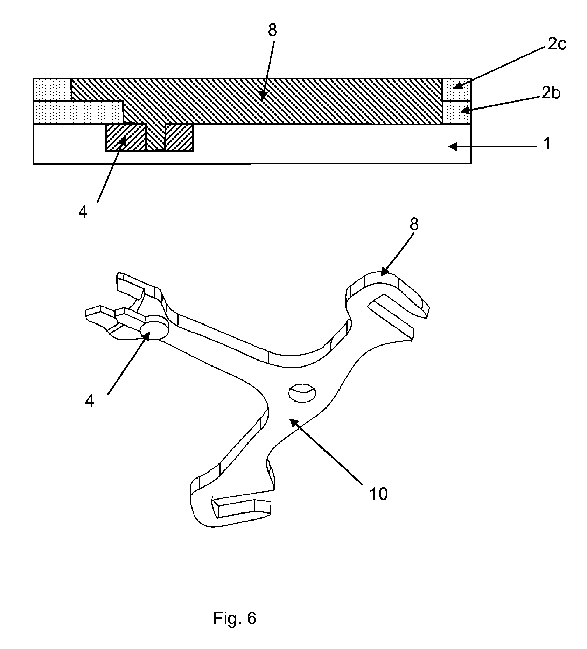

La figure 6 illustre une pièce 10 d'horlogerie, en l'occurrence une ancre à dard fabriquée en utilisant un premier moule gravé dans le substrat 1 pour réaliser le dard formé par la première couche métallique 4 du premier niveau. Le second niveau formant l'ancre est réalisé à l'aide de deux moules en photoresist superposés dans les lesquels la seconde couche métallique 8 est déposée de manière à croître à la fois sur le substrat et le long du flanc d'un orifice de la première couche métallique et dans les deux moules en photoresist (cf. la variante de la figure 5 avec un moule de photoresist supplémentaire formé entre les étapes E et F).

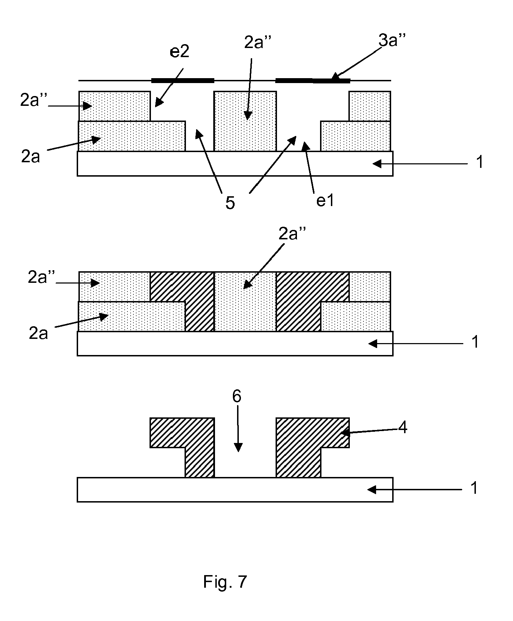

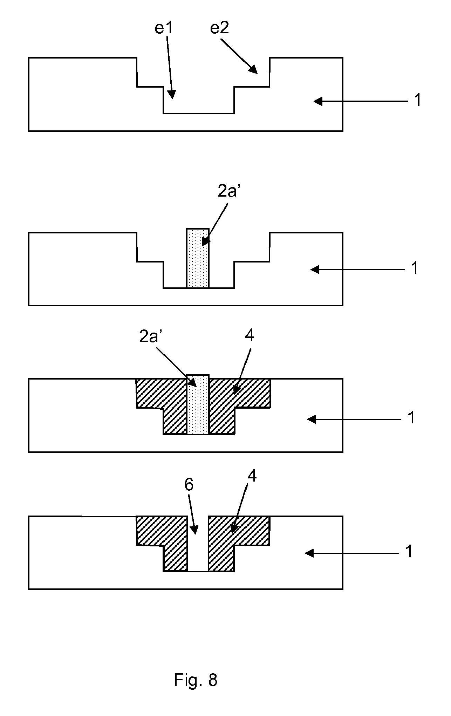

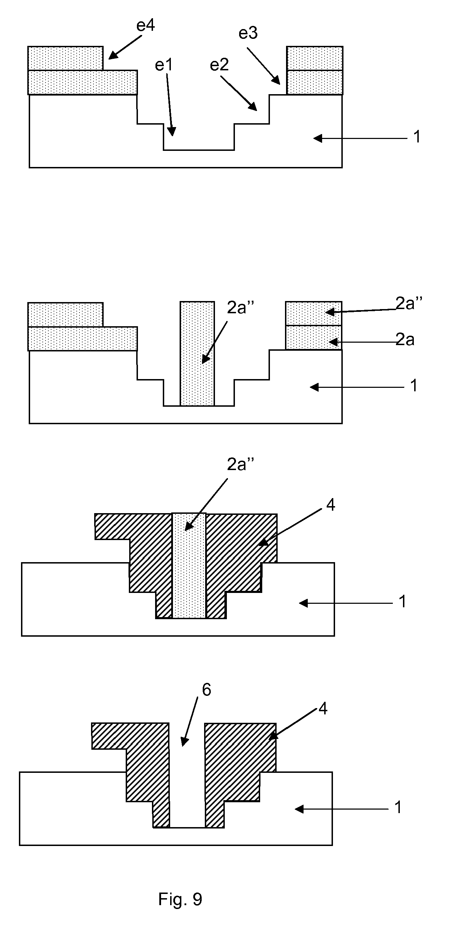

Pour des raisons de simplification, les figures 1 à 5 illustrent des variantes dans lesquelles le premier moule réalisé lors de l'étape A comporte un seul étage. Les figures 7 et 8 représentent des variantes dans lesquelles le premier moule comporte deux étages et la figure 9 un moule à quatre étages. Ce moule constituant le premier niveau de la pièce sert à l'électroformage de la première couche métallique 4. Le second niveau de la pièce constitué par la seconde couche métallique 8 imbriquée dans la première couche métallique 4 est réalisé de manière similaire aux variantes des figures 1 à 5, étapes D à F.

Le premier moule de la variante de la figure 7 comporte deux étages e1 et e2 formé dans deux couches de photoresist 2a et 2a" réalisées chacune par dépôt de photoresist, irradiation à travers un photomasque et polymérisation. La couche métallique 4 croît depuis le substrat au fond de la cavité et le long des flancs des deux étages du moule. La couche 2a" réalisée avec le photomasque 3a" laisse un espace 6 destiné à l'imbrication de la seconde couche métallique du second niveau comme dans les variantes précédentes.

Le contour de la cavité du moule formée par un étage supérieur s'étend entièrement ou en parties au-delà du contour de la cavité d'un étage inférieur. Certaines portions du contour de deux étages peuvent coïncider et former un flanc continu d'épaisseur égale à celle de deux étages. Dans les autres portions du contour de la cavité où l'étendue de l'étage supérieur est plus grande, le flanc est discontinu en épaisseur et forme une marche d'escalier.

En d'autres termes, la projection du contour d'un étage inférieur de la cavité du moule est soit entièrement inscrite dans la projection du contour d'un étage supérieur, soit partiellement inscrite avec des portions tangentes au contour d'un étage supérieur.

La variante de la figure 8 est basée sur celle de la figure 5 avec un moule à deux étages e1 et e2 gravés dans le substrat 1. Une couche supplémentaire de photoresist 2a' est déposée sur le substrat au fond de la cavité afin de créer un espace 6 dans la première couche métallique 4.

La variante mixte de la figure 9 illustre un exemple d'une combinaison des procédés de gravure profonde du substrat et du procédé LIGA pour réaliser un premier moule à quatre étages e1, e2, e3, e4. Les deux premiers étages e1 et e2 sont obtenus par gravure profonde, cf. figure 8 tandis que les deux étages supérieurs sont obtenus par le procédé LIGA, cf. figure 7.

Le moule illustré par la figure 9 comporte à la fois des portions de flanc continues et discontinues en épaisseur, notamment entre les étages e2 et e3 et entre les étages e3 et e4.

La méthode de l'invention et ses variantes s'appliquent également pour des pièces de plus de deux niveaux. Dans ce cas, les étapes D, E et F sont répétées autant de fois qu'il y a de niveaux à former au-dessus du premier niveau. Chaque niveau nécessite un photomasque particulier configuré de manière à libérer au moins un espace dans la couche métallique du niveau précédent et/ou sur son contour pour permettre l'imbrication des niveaux suivants les uns dans les autres.

## Revendications

1. Méthode de fabrication de pièces métalliques comportant au moins deux niveaux obtenus par photolithographie et électroformage, cette méthode comprenant les étapes suivantes:
- préparer un premier moule comportant une cavité avec au moins un étage, ledit premier moule définissant un premier niveau,
- déposer une première couche métallique (4) par électroformage dans la cavité du premier moule,
- usiner par un procédé mécanique la première couche métallique (4) à une épaisseur prédéfinie,
- enlever le photoresist polymérisé du premier moule,
- déposer et irradier au travers d'un second photomasque (3b), une seconde couche de photorésist (2b) appliquée sur le substrat (1), en masquant tout ou partie de la première couche métallique (4) à l'exception d'au moins un flanc de la première couche métallique (4), ladite seconde couche de photoresist (2b), étant d'épaisseur égale ou supérieure à l'épaisseur de la première couche métallique (4), constituant la cavité d'un moule de photoresist d'un second niveau,
- polymériser la seconde couche de photorésist (2b) et éliminer la couche de photorésist non polymérisée, de manière à laisser une partie de la couche de photoresist constituant la cavité du moule de photoresist du second niveau, et au moins un espace (6) traversant libre de photoresist adjacent au flanc de la première couche métallique (4),
- déposer une seconde couche métallique (8) par électroformage dans la cavité du moule de photoresist du second niveau de sorte que le métal de la seconde couche (8) commence sa croissance dans l'espace (6) de la première couche métallique (4) en créant une liaison intime entre la seconde couche métallique (8) et au moins un flanc de la première couche métallique (8) et résultant en un auto-assemblage entre les deux niveaux,
- usiner par un procédé mécanique la seconde couche métallique (8) à une épaisseur prédéfinie,
- enlever le photoresist polymérisé du moule du second niveau ainsi que le substrat (1),
- obtention d'une pièce métallique comportant deux niveaux superposés imbriqués l'un dans l'autre, non nécessairement inclus l'un dans l'autre, le contour ainsi que le positionnement relatif de chaque niveau ainsi que leur positionnement relatif étant défini par photolithographie.

2. Méthode selon la revendication 1 **caractérisée en ce qu'**elle comprend, après la polymérisation de la seconde couche de photoresist (2b), les étapes de formation du second moule en photoresist suivantes :
- déposer et irradier au travers d'un troisième photomasque (3c), une troisième couche de photorésist (2c) appliquée sur le substrat (1) en masquant au moins une zone définie par le flanc de la première couche métallique (4),
- polymériser la troisième couche de photoresist (3c) et éliminer la couche de photorésist non polymérisée, la partie de photoresist restante constituant une cavité du second moule, l'espace (6) dans la première couche métallique (4) étant libre de photoresist.

3. Méthode selon la revendication 1 **caractérisée en ce que** l'étape de préparation d'un étage du premier moule comprend les opérations suivantes :
- déposer et irradier au travers d'un premier photomasque (3a), une première couche de photorésist (2a) appliquée sur un substrat (1),
- polymériser la première couche de photorésist (2a)
- éliminer la couche de photorésist non polymérisée, la partie de photoresist restante constituant le premier moule formé par le photoresist et comportant au moins une cavité.

4. Méthode selon la revendication 1 **caractérisée en ce que** l'étape de préparation d'un étage du premier moule comprend les opérations suivantes :
- déposer et irradier au travers d'un premier photomasque (3a), une première couche de photorésist (2a) appliquée sur un substrat (1),
- polymériser la première couche de photorésist (2a) et éliminer la couche de photorésist non polymérisée,
- graver la partie du substrat non masquée par le photoresist, la partie gravée du substrat constituant une cavité (5a) d'une première partie du premier moule (5),
- déposer et irradier au travers d'un photomasque supplémentaire (3a') une couche supplémentaire de photoresist (2a') appliquée sur le substrat et dans la cavité (5a) de la partie gravée,
- polymériser la couche supplémentaire de photorésist (2a') et éliminer la couche de photorésist non polymérisée, la partie de photoresist restante constituant une seconde partie du premier moule (5) et empêchant l'électroformage subséquent de remplir totalement la cavité (5a) gravée dans le substrat,

5. Méthode selon l'une des revendications 1 à 4 **caractérisée en ce que** l'épaisseur de la seconde couche de photoresist (2b) est plus grande que l'épaisseur de la première couche métallique (4), ladite seconde couche de photoresist (2b) recouvrant une partie de la première couche métallique (4) forme un espace supplémentaire (9) se superposant à l'espace (6) de la première couche métallique (4).

6. Méthode selon la revendication 5 **caractérisée en ce que** la cavité du moule de photoresist formant le second niveau comporte trois niveaux constitués par la superposition de l'espace (6) de la première couche métallique (4), de l'espace (9) constitué par la surépaisseur de la seconde couche de photoresist (2b) et de l'espace (7) formé par la troisième couche de photoresist (2c).

7. Méthode selon l'une des revendications 1 à 4 **caractérisée en ce que** l'espace (6) dans la première couche métallique (4) est entièrement entouré par le métal de ladite première couche métallique (4) en formant un orifice dont la forme est définie par le premier photomasque (3a), ledit orifice (6) traverse entièrement la première couche métallique (4) jusqu'au substrat (1), la seconde couche métallique (8) remplissant entièrement l'orifice (6) à partir du substrat (1) en se liant intimement avec la première couche métallique (4) par les flancs de l'orifice (6).

8. Méthode selon l'une des revendications 1 à 4 **caractérisée en ce que** l'espace (6) dans la première couche métallique (4) défini un contour comprenant au moins une partie concave et une partie convexe formé par une portion de flanc de la première couche métallique (4) et par une portion de flanc de la seconde couche de photoresist (2b), la seconde couche métallique (8) enrobant le contour de la première couche métallique (4) en remplissant l'espace (6) à partir du substrat (1).

9. Méthode selon l'une des revendications 7 ou 8 **caractérisée en ce que** le flanc de la première couche métallique le long duquel la liaison entre les niveaux est effectuée est optimisé de manière à maximiser la surface de contact.

10. Méthode selon l'une des revendications 1 à 9 **caractérisée en ce que** l'électroformage de la première couche métallique est réalisé en un premier métal et l'électroformage de la deuxième couche métallique est réalisé en un deuxième métal différent du premier métal.

11. Pièce composée d'au moins deux niveaux constitués chacun par une couche métallique obtenue par photolithographie, grâce à un moule de photoresist ou gravé dans le substrat, et par électroformage, **caractérisée en ce que** la couche métallique du second niveau est imbriquée et intimement liée à la couche métallique du premier niveau par au moins une portion de surface et de flanc de la couche métallique dudit premier niveau et **en ce que** le second niveau s'étend partiellement ou entièrement sur le premier niveau et sur une zone extérieure au voisinage dudit premier niveau de sorte que le contour d'une projection orthogonale du second niveau englobe tout ou partie du contour du premier niveau.

12. Pièce selon la revendication 9, **caractérisée en ce qu'**elle comprend un niveau intermédiaire s'étendant partiellement sur le premier niveau et situé entre le premier et le second niveau, ledit second niveau s'étendant partiellement ou entièrement sur le niveau intermédiaire et sur une zone extérieure au voisinage dudit niveau intermédiaire de sorte que le contour d'une projection orthogonale du second niveau englobe tout ou partie le contour du premier niveau.

13. Pièce selon la revendication 11 ou 12 **caractérisée en ce que** la couche métallique du premier niveau est constituée par un premier métal et la couche métallique du second niveau est constituée par un deuxième métal différent du premier métal.

14. Pièce selon l'une des revendication 11 à 13, **caractérisée en ce que** la couche métallique du second niveau est imbriquée et intimement liée à la couche métallique du premier niveau à travers au moins un orifice formé dans la couche métallique du premier niveau.

15. Pièce selon l'une des revendications 11 à 13, **caractérisée en ce que** la couche métallique du second niveau est imbriquée et intimement liée à la couche métallique du premier niveau par au moins une portion de flanc formant un contour comprenant une suite de parties convexes et concaves de sorte que la couche métallique du second niveau enrobe une portion de la couche métallique du premier niveau.
